Europäisches Patentamt

European Patent Office

Office européen des brevets

(11) Numéro de publication: **0 246 136 B1**

(12) **FASCICULE DE BREVET EUROPEEN**

(45) Date de publication de fascicule du brevet:
20.03.91

(51) Int. Cl.⁵: **G01R 33/40**

(21) Numéro de dépôt: **87400990.5**

(22) Date de dépôt: **29.04.87**

(54) **Procédé de réglage des correcteurs d'homogénéité du champ magnétique créé par un aimant.**

(30) Priorité: **13.05.86 FR 8606861**

(43) Date de publication de la demande:
**19.11.87 Bulletin 87/47**

(45) Mention de la délivrance du brevet:
**20.03.91 Bulletin 91/12**

(84) Etats contractants désignés:
**CH DE GB IT LI NL**

(56) Documents cités:
**EP-A- 0 179 370**
**FR-A- 2 567 648**
**GB-A- 2 155 642**

**PHYSICS IN MEDICINE AND BIOLOGY, vol. 30, no. 8, août 1985, pages 741-770, The Institute of Physics, Londres, GB; R.E. GORDON: "Magnets, molecules and medicine"**

**REVIEW OF SCIENTIFIC INSTRUMENTS, vol. 57, no. 4, avril 1986, pages 683-688, American Institute of Physics, New York, US; C.B. AHN et al.: "Magnetic field homogeneity correction algorithm using pseudoinversion formula for NMR imaging"**

(73) Titulaire: **GENERAL ELECTRIC CGR S.A.**
**100, rue Camille-Desmoulins**
**F-92130 Issy les Moulineaux(FR)**

(72) Inventeur: **Aubert, Guy**
**THOMSON-CSF SCPI 19, avenue de Messine**
**F-75008 Paris(FR)**

(74) Mandataire: **Ballot, Paul Denis Jacques et al**
**Cabinet Ballot-Schmit 7, rue le Sueur**
**F-75116 Paris(FR)**

## Description

La présente invention est due à la collaboration du Service National des Champs Intenses (Directeur M. Guy AUBERT), et elle a pour objet un procédé de réglage des correcteurs d'homogénéité du champ magnétique créé par un aimant. Elle trouve son application particulièrement dans le domaine médical où des aimants sont utilisés pour procéder à des investigations non invasives, en appliquant des méthodes d'imagerie par résonance magnétique nucléaire. Elle peut néanmoins trouver son application dans d'autres domaines, notamment dans celui de la recherche scientifique où des champs intenses produits par des aimants sont utilisés.

La résonance magnétique nucléaire est un phénomène d'oscillation du moment magnétique des noyaux des atomes ou molécules d'un corps à une fréquence qui dépend de l'intensité d'un champ magnétique dans lequel baigne ce corps. Il ressort de cette constatation que si l'intensité du champ magnétique varie, la fréquence du phénomène de résonance varie également. Aussi, pour des raisons technologiques et techniques, dans de telles expérimentations, il est de la plus haute importance que le champ produit par l'aimant soit très homogène dans sa zone d'intérêt. L'homogénéité requise est couramment de l'ordre de quelques parties par million dans le domaine médical, voire de quelques parties par milliard dans le domaine scientifique. Pour arriver à ce but, on essaye de construire des aimants donnant un champ le plus parfaitement homogène.

Malheureusement, quel que soit le soin apporté à la construction des aimants, leur réalisation n'est jamais aussi parfaite que la théorie qui a conduit à leur calcul. Par ailleurs, même si ce défaut peut être éliminé, l'aimant pour être utilisé doit matériellement être placé en un endroit donné. Or aucune des régions de l'espace sur la terre, dans un environnement industriel ou urbain, n'est totalement exempte d'éléments magnétiques perturbateurs. Il en résulte qu'une fois installé sur site, le champ produit dans la zone d'intérêt d'un aimant présente des inhomogénéités qu'il faut maintenant tenter de corriger.

Le principe de la correction des inhomogénéités de champ est celui de la superposition : on ajoute des bobines, des pièces magnétiques, ou tous autres moyens de produire des champs magnétiques, de manière à corriger les imperfections du champ principal et de manière à produire un champ global homogène. La théorie de la correction a été développée à l'origine par MM. SAUZADE M. et KAN S. K. dans la revue "Advances In Electronics and Electron physics", volume 34, 1973 Academic Press, et une relation de leurs travaux est faite dans la collection des ` "Techniques de l'Ingénieur" chapître E 4351. Les auteurs sont partis du principe qu'un champ magnétique, en un point quelconque de l'espace, peut être exprimé mathématiquement sous la forme d'une expression dite analytique du type $B_z(x,y,z) = f(x,y,z)$. Dans cette expression $B_z$ représente la composante principale du champ en un point de coordonnée x,y,z, et f est la fonction analytique utilisée. La fonction f que ces auteurs ont explicitée s'écrit sous la forme d'une décomposition polynomiale en x,y,z, d'ordre, ou de puissance, croissant de zéro à l'infini. Sous certaines restrictions, notamment de proximité des régions intéressées aux moyens de corrections qui en mofident le champ, les termes d'ordres élevés de cette expression peuvent être négligés.

Ces auteurs ont pu tirer de cette décomposition un principe général d'indépendance des corrections. Cette indépendance signifie. qu'il est possible de construire des moyens de correction agissant sur des ordres supérieurs, mais pas inférieurs, à un ordre donné. Par exemple pages 4 à 6 de la collection précitée, ces auteurs décrivent une série de douze bobines pour corriger successivement des inhomogénéités de champ jusqu'aux ordres 4 de l'expression analytique en question. Ainsi, par exemple, après avoir corrigé les inhomogénéités de premier ordre du champ principal avec une première bobine conçue dans ce but, on peut corriger des inhomogénéités de deuxième ordre du champ principal, auxquelles se sont ajoutées entre temps des inhomogénéités de deuxième ordre dues à la première bobine, au moyen d'une deuxième bobine de correction. La mission de cette deuxième bobine est de corriger les inhomogénéités de deuxième ordre et de ne pas produire d'inhomogénéités de premier ordre. Ainsi de suite, la correction s'effectue successivement pour tous les ordres. Pour le réglage, après chaque correction, avant de passer à la correction suivante, on remesure le champ. Puis on estime la correction à effectuer en comparant les défauts de valeur de champ en des endroits de mesure à des champs qu'on peut obtenir avec la bobine suivante. Cette procédure est laborieuse, elle n'aboutit à de bons résultats qu'après de nombreuses tentatives. Par ailleurs le réglage n'est jamais effectué au mieux.

Dans leur complexité, la théorie et le réglage se simplifient par une possibilité de différenciation entre des corrections dites axiales, celles qui correspondent aux variations du champ principal que l'on rencontre quand on se déplace parallèlement à ce champ dans la zone d'intérêt, et des corrections dites radiales qui correspondent aux inhomogénéités que l'on rencontre quand on se déplace perpendiculairement à l'orientation de ce champ principal. Il ressort de cette étude que les corrections axiales et radiales sont indépendantes les unes des autres, au moins si on ne se préoccupe que de la composante du champ principal orientée selon l'orientation recherchée de ce champ. Les auteurs précités ont ainsi élaboré, dans un exemple, douze bobines propres à constituer un système de correction complet. Ce système est universellement connu. Il est mis en oeuvre par beaucoup de constructeurs.

Plus récemment Mme F. ROMEO et Mr D.I. HOULT ont publié dans la revue MAGNETIC RESONANCE IN MEDICINE 1,44-65 de 1984 un article intitulé "MAGNET FIELD PROFILING : ANALYSIS AND CORRECTING COIL DESIGN". La démarche de ces auteurs est complémentaire de celle des premiers. Ils montrent en particulier que pour l'expression analytique du champ la décomposition polynomiale à base de coordonnées cartésiennes n'est pas la meilleure.

Au contraire, les coordonnées sphèriques qui mènent à une expression analytique du champ sous la forme d'une combinaison d'harmoniques sphériques sont plus propices à la compréhension et à la réalisation des structures types de moyens de correction à construire. Les derniers auteurs enseignent en outre une méthodologie de correction. Cette méthodologie comporte les étapes suivantes. Premièrement le champ principal, à corriger, est mesuré. On peut arriver à ce résultat par des moyens classiques. Une fois mesuré on en cherche une expression analytique dans la forme préférée. De cette expression analytique, que l'on compare à une expression analytique idéale (représentant un champ idéal correspondant, par exemple, à un $B_z$ constant), on déduit l'expression analytique d'un champ correcteur à produire. Enfin, par des considérations analogues à celles qui ont prévalues pour les précédents auteurs, il est proposé de construire des bobines, ou tout autre moyen de correction, pour arriver à l'homogénéité recherchée du champ principal. Cette méthodologie savante présente cependant un inconvénient majeur : elle n'est pas industrielle. En effet, elle suppose que les systèmes de correction doivent être calculés, fabriqués, et installés spécifiquement pour chaque aimant. Techniquement et financièrement cette méthodologie est inapplicable en dehors du laboratoire. D'une part parce qu'elle correspond à un métier nouveau non encore bien représenté dans l'industrie : celui de calculateur - constructeur à la demande de bobines de correction ; et d'autre part parce que même dans ce cas le coût et le temps passé à de telles réalisations seraient prohibitifs. Un autre exemple de l'état de la technique est montré dans GB-A-2155642.

La présente invention a pour objet de résoudre les inconvénients cités en proposant une méthode qui perfectionne ces deux enseignements pour les rendre plus efficaces et plus industriels. Avec le procédé de réglage de l'invention, on est capable de régler l'homogénéité d'un aimant en quelques heures alors qu'il faut quelques jours avec le premier état de la technique cité. On utilise par ailleurs pour faire le réglage des moyens de correction standard et non pas spécialisés. Ces moyens qui peuvent être des bobines sont seulement indépendants, au sens de l'invention, pour les ordres de correction auxquels ils s'attaquent. Le procédé de l'invention est même tel qu'il est possible de régler le champ d'un aimant alors que cet aimant est muni de moyens de correction dont on ne connait pas la structure et sur lesquels on ne peut agir que par leurs commandes.

La présente invention a pour objet un procédé de réglage des correcteurs d'homogénéité du champ magnétique créé par un aimant caractérisé en ce qu'il comporte les phases suivantes :
- on mesure le champ réel créé par l'aimant,
- on calcule l'expression analytique, suivant une base de fonctions orthogonales, du champ mesuré,
- on calcule les expressions analytiques, suivant la même base, des champs produits par les moyens de correction en fonction de leur état de réglage,
- on calcule l'expression analytique, suivant la même base, d'un champ idéal à obtenir avec l'aimant,
- on procède à une composition algébrique des expressions analytiques des champs de correction pour la rendre égale, et de signe contraire, à la différence des expressions analytiques des champs réel et idéal,
- et on règle les moyens de correction en fonction des résultats de cette composition algébrique.

L'invention sera mieux comprise à la lecture de la description qui suit et à l'examen de la figure qui l'accompagne. Cette description n'est donnée qu'à titre indicatif et nullement limitatif de l'invention. En particulier l'application au domaine médical n'est pas restrictive

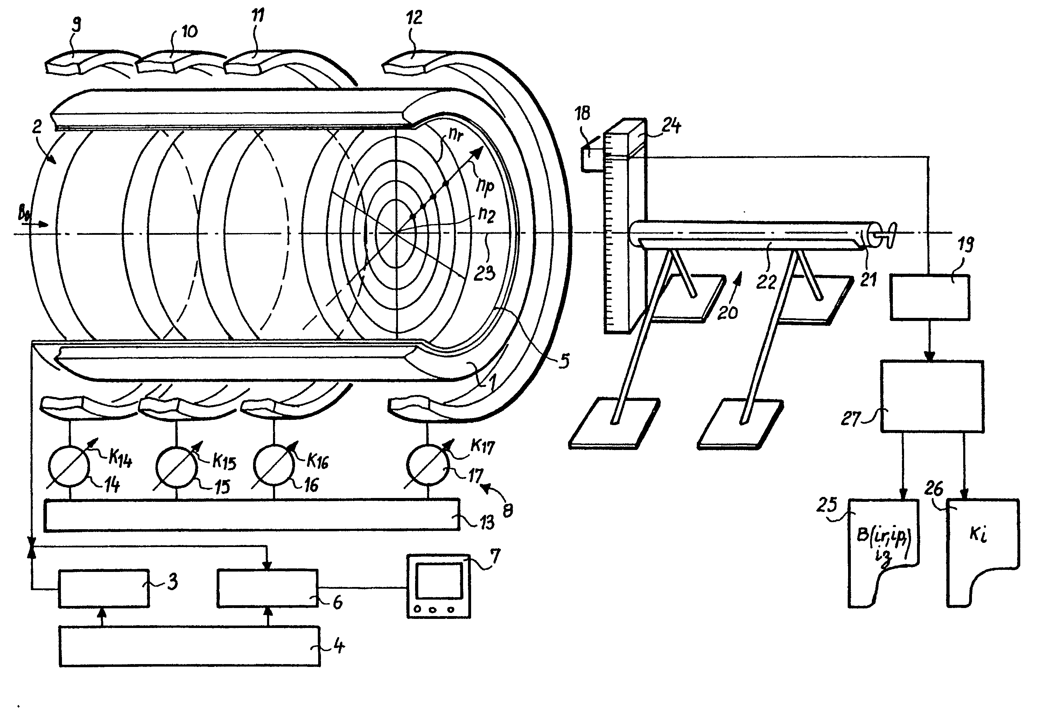

La figure 1 unique représente schématiquement en perspective un appareil d'imagerie par résonance magnétique nucléaire du type de ceux utilisés par exemple dans le domaine médical. Un aimant 1 y produit un champ intense $B_0$ dans un volume d'intérêt 2 ici d'aspect cylindrique circulaire. Des moyens générateurs 3 sous le contrôle d'une unité de commande 4 sont prévus pour alimenter des moyens 5 d'excitation radiofréquence et de différenciation spatiale du moment magnétique de particules placées pour examen dans le volume 2. Les moyens 5, notamment dans leur aspect radiofréquence, sont aussi utilisés pour mesurer une onde de désexcitation représentative du phénomène de résonance magnétique. Ils sont reliés à des moyens 6 de réception et de traitement du signal mesuré. Les moyens 6, également sous le contrôle des moyens de commande 4 peuvent produire des images de coupe du corps examiné. Ces images peuvent être affichées sur des moyens de visualisation 7.

Selon l'enseignement préconisé par les deux états de la technique cités, ce système comporte en outre un ensemble 8 de moyens de correction comportant en particulier, dans un exemple, un certain nombre de bobines schématiquement représentées telles que 9,10,11, etc 12. Ces bobines sont alimentées en courant par un générateur 13 par l'intermédiaire de commandes de réglage de l'intensité du courant respectivement 14 à 17. Les commandes 14 à 17 servent à effectuer le réglage des moyens de correction. Comme il a été indiqué ci-dessus les moyens 8, dans l'invention, peuvent être des moyens standards (en général des bobines correctrices au nombre de 12) ou spécialisés. La structure de ces moyens, de ces bobines, peut être connue ou même inconnue de l'opérateur qui va effectuer leur réglage selon l'enseignement de l'invention.

Au moyen d'une sonde 18, reliée à un Gaussmètre 19 et supportée par un dispositif d'exploration 20, on mesure le champ réel créé par l'aimant 1 dans le volume 2. Le dispositif d'exploration 20 comporte schématiquement un arbre 21 qui peut coulisser et tourner sur lui-même à l'intérieur d'un palier 22. L'axe de l'arbre 21 est aligné avec l'axe 23 du volume cylindrique circulaire 2. A un bout de l'arbre 21, est montée une échelle transversale 24 sur laquelle peut être fixée la sonde 18. Suivant la position en rotation de l'arbre 21, l'échelle 24 est orientée selon une parmi np directions possibles. La hauteur de la position de la sonde 18 sur l'échelle 24 peut être prise parmi nr positions possibles. Enfin l'arbre 21 peut coulisser dans le support 22 pour que la sonde puisse se trouver successivement à nz abscisses le long de l'axe 23. Un triplet de nombres ir ,ip et iz représente ainsi les coordonnées cylindriques d'un point quelconque du volume 2 où on peut placer la sonde 18, et pour lequel on mesure le champ $B_0$ réel. Dans l'invention les mesures effectuées par le Gaussmètre 19 sont introduites dans un ordinateur 27 qui les édite dans une liste 25. En application du procédé de l'invention l'ordinateur 27 peut également éditer une liste 26 d'indications $K_i$ des valeurs de réglage des commandes de réglage 14 à 17.

Quand les mesures correspondant à la liste 25 sont connues, on peut, au moyen d'un logiciel approprié utilisant en particulier l'enseignement évoqué par le deuxième état de la technique cité, calculer l'expression analytique du champ $B_0$ sous la forme préférée d'une décomposition en harmoniques sphériques. Ces harmoniques sphériques ont la particularité d'être orthogonales. Cette expression analytique peut alors s'écrire de la manière suivante :

$$\frac{B_z (r,\theta,\varphi)}{B_s} = H_0 + \sum_{n=1}^{\infty} \left(\frac{r}{r_0}\right)^n \left[ H_n \cdot P_n (\cos.\theta) \right]$$

$$+ \sum_{n=1}^{\infty} \left(\frac{r}{r_0}\right)^n \left[ \sum_{m=1}^{m=n} I_n^m \cos m\, \varphi \sqrt{\frac{(n-m)\,!}{(n+m)\,!}}\; P_n^m (\cos \theta) \right]$$

$$+ \sum_{n=1}^{\infty} \left(\frac{r}{r_0}\right)^n \left[ \sum_{m=1}^{m=n} J_n^m \sin m\, \varphi \sqrt{\frac{(n-m)\,!}{(n+m)\,!}}\; P_n^m (\cos \theta) \right]$$

Dans cette formule $B_z$ est la composante selon l'axe 23 du champ $B_0$ créé par l'aimant 1, $B_s$ est un champ de référence permettant de définir des coefficients $H_n$, $I_n^m$ et $J_n^m$ sans dimension. Le rayon réduit $r/r_0$ mesure le module de la distance r d'un point quelconque du volume d'intérêt au rayon $r_0$ d'une sphère utile. Les fonctions $P_n (\cos \theta)$ et $P_n^m (\cos \theta)$ sont respectivement les polynomes de Legendre et les polynomes de Legendre associés d'indices n et m. Les coefficients $H_n$, $I_n^m$ et $J_n^m$ sont représentatifs du champ B : pour un champ $B_z$ mesuré ils sont connus. Dans la pratique, l'ordinateur 27 peut être programmé pour accomplir ce calcul à partir des mesures. On utilise de préférence la correspondance exacte qui existe entre les coordonnées sphériques r, $\theta$, et $p$ de l'expression analytique et le triplet des nombres ir , ip et iz qui ont servi pour la mesure du champ.

Dans l'invention on a remarqué que s'il était possible de connaître l'expression analytique du champ principal $B_0$, il était aussi possible de connaître l'expression analytique du champ produit par l'un quelconque (9 à 12) des moyens de correction 8. Il est donc possible d'écrire le champ relatif à chacun de ces moyens sous la forme d'une expression analytique similaire à celle vue plus haut et à chaque fois paramétrée par un coefficient $K_i$ : $K_{14}$ à $K_{17}$. Ce coefficient, dans le cas de bobines est proportionnel au courant qui les traverse. Par ailleurs, il est aussi possible de calculer l'expression analytique, par exemple aussi selon une décomposition en harmoniques sphériques, d'un champ idéal à obtenir et qui correspondrait par exemple à un $B_z$ constant.

La soustraction de l'expression analytique réelle de l'expression analytique idéale, par exemple correspondant à $B_z$ constant, donne une expression analytique de correction. Cette expression analytique de correction ainsi que les expressions analytiques, paramétrées par $K_i$, des champs magnétiques de correction peuvent s'écrire de manière concordante. Par exemple tous les coefficients $H_n$, $I_n^m$, $J_n^m$ du champ de correction porteront un indice cor ; les mêmes coefficients correspondant aux commandes (14 à 17) comporteront des indices i où i peut valoir de 1 à N, N étant le nombre des commandes. Quand le champ produit par les moyens de correction est égal, et de signe contraire, au champ de correction, on peut écrire que l'expression analytique de correction est égale, et de signe contraire, à une composition algébrique des expressions analytiques (à chaque fois multipliées par des coefficients $K_i$) des champs produits par les bobines de correction. Ceci peut encore s'écrire de la manière suivante :

$$EA_{cor.} = - \sum_{1}^{N} K_i . EA_i$$

où EA signifie expression analytique. Dans l'invention on a alors remarqué que cette égalité conduisait à une pluralité d'égalités ou d'équations de la forme :

$$H_{n_{cor.}} = - \sum_{1}^{N} K_i . H_{n_i}$$

$$I_{n_{cor.}}^m = - \sum_{1}^{N} K_i . I_{n_i}^m$$

$$J_{n_{cor.}}^m = - \sum_{1}^{N} K_i . J_{n_i}^m$$

où n et m peuvent être quelconque (entre 1 et l'infini) puisque les fonctions $P_n$ et $P_n^m$ sont indépendantes. Dans ce système d'équations les inconnues sont les $K_i$. Pour une valeur de N donnée, (N = 12 dans le premier état de la technique cité), ce système d'équations ne peut admettre de solution si n ou m peuvent être infinis. En effet ceci conduit à une infinité d'équations indépendantes avec un nombre limité (N) d'inconnues. Par contre, en se gardant une possibilité de tolérance sur le résultat à atteindre, on peut admettre qu'au delà d'un certain ordre les équations ne seront plus vérifiées. Par exemple on peut admettre qu'au-delà de n = 4 les coefficients de l'expression analytique du champ de correction ainsi que ceux des moyens de correction sont suffisamment faibles pour être négligés. Il en résulte alors que l'on peut se trouver confronté à un système d'équations comportant un nombre donné N d'équations et un même nombre donné N d'inconnues. Un tel système, connu mathématiquement sous le nom de système de CRAMER, est soluble. La solution qui comporte notamment une opération d'inversion de matrice est typiquement de celles qui peuvent être exécutées par l'ordinateur 27.

Ainsi il résulte que, connaissant tous les coefficients de décomposition en harmoniques sphériques liés au champ de correction et liés à chacun (i) des moyens de correction, il est possible de trouver simplement la liste des valeurs $K_i$ de réglage de ces moyens. Dans le cas de bobines les valeurs $K_i$ sont proportionnel-

les aux courants qui traversent chacune des bobines. On conçoit cependant que cette affirmation ne serait pas vraie si au lieu de disposer d'un nombre N de bobines de correction indépendantes on disposait N fois de la même bobine. Cette impossibilité s'exprime autrement en disant qu'il est nécessaire pour qu'une solution puisse être trouvée selon le procédé de calcul de l'invention que les bobines de correction produisent des champs qui, au regard de la décomposition en harmoniques sphériques (du moins pour les premiers ordres intéressés), puissent être considérés comme algébriquement indépendants. Cette indépendance a par exemple pour effet qu'il doit être impossible de reproduire le champ d'une quelconque bobine avec une combinaison algébrique des champs produits par les autres bobines de correction, et ceci au moins pour les premiers ordres considérés. Cependant, on peut se rendre compte que cette contrainte supplémentaire d'indépendance dans l'invention est très simple à réaliser et est beaucoup moins contraignante que celle correspondant à l'état de la technique cité. Dans celui-ci en effet elle s'exprime différemment, mais on y attend quand même d'une bobine corrigeant des inhomogénéités à un ordre donné qu'elle n'induise pas d'inhomogénéités à un ordre inférieur (ou encore qu'une bobine de correction des inhomogénéités radiales n'induise pas d'inhomogénéités axiales et vice versa).

La connaissance de la décomposition en harmoniques sphériques du champ de chacune des bobines de correction peut être connue de diverses manières. En connaissant la structure des bobines de correction et en suivant l'enseignement du deuxième état de la technique citée, il est possible de calculer l'expression analytique du champ théorique qu'elles produisent. En fait ces bobines, comme l'aimant à corriger, ne produisent pas un champ théorique mais un champ réel légèrement différent du champ théorique. Il en résulte une différence de l'expression analytique qui correspond à ce champ réel. Si on admet que le champ principal connaît des inhomogénéités de l'ordre du millième, le champ nominal produit par les moyens de correction doit être de cet ordre de grandeur. Construit avec le même soin que l'aimant, les moyens de correction connaissent alors des défauts du même ordre. En conséquence, les inhomogénéités des champs de correction sont elles-mêmes du millième du millième, c'est-à-dire de l'ordre du millionnième du champ principal. Dans ces conditions, dans une première approche, elles peuvent être négligées et l'expression analytique du champ théorique peut être utilisée.

Cependant si tel n'est pas le cas, ou dans un cas particulièrement intéressant si la structure des moyens de correction n'est pas connue, il est possible de calculer l'expression analytique du champ que chacun d'eux produit. Par exemple pour des bobines on les fait traverser tour à tour par un courant nominal, proportionnel à un coefficient $K_0$, et on mesure le champ réel qu'elles produisent. Puis on calcule de la même manière que pour le champ principal la décomposition analytique à laquelle ce champ correspond. La présente invention enseigne ainsi que, quelque soient les moyens de corrections existants et pourvu qu'ils soient indépendants au sens de l'invention, il est possible de remédier aux inhomogénéités dès qu'on en a calculé l'expression analytique.

Un autre avantage de la méthode consiste à indiquer avec quelle précision géométrique doit être menée l'exploration du volume 2, ainsi que l'ordre des expressions analytiques de champ dont il faut se servir pour réduire des inhomogénéité jusqu'à une valeur donnée. Le nombre de points de mesure est égal à P où :

$$P = nz \ (1 + (nr - 1) \ np)$$

Dans la pratique, on s'arrange pour que nz soit un nombre impair de manière à ce qu'une des abscisses corresponde au centre du volume d'intérêt 2. Pour nz , nr , et np connus, on peut donc relever le champ en P points et calculer son expression analytique. Cette expression est forcement limitée à un ordre donné. Connaissant cette expression analytique, on calcule le champ théorique auquelle elle correspond. Ce champ théorique est différent du champ réel mesuré puisqu'on a négligé les ordres supérieurs dans l'expression analytique. On calcule alors l'écart quadratique moyen entre le champ réel mesuré et le champ théorique calculé. Si cet écart quadratique moyen est supérieur à la précision de mesure du Gaussmètre 19 (ou aussi à la tolérance recherchée sur l'homogénéité), on en déduit que l'expression analytique est incorrecte. Elle peut être incorrecte pour deux raisons. Premièrement parce que le nombre de points de mesure est insuffisant. Deuxièmement, corrélativement, parce que l'ordre de décomposition en harmoniques sphériques est insuffisant également. Il convient dans ce cas d'augmenter nz , nr , np et l'ordre de décomposition jusqu'à ce que l'écart quadratique moyen soit de l'ordre ou inférieur à la précision voulue.

La décomposition en harmoniques sphériques nous apprend que m doit être inférieur ou égal à n . Sachant que m y apparaît dans les fonctions propres sous la forme de cos m et sin m , il en résulte que la limitation à une valeur donnée du nombre np limite le nombre m . En effet, l'exploration radiale selon un nombre donné np de directions privilégiées est identique à un échantillonnage, et en appliquant la théorie de Shannon, on sait qu'on ne peut pas valablement définir de fonctions propres sin m et cos m où m est supérieur à la partie entière de np/2. Des considérations mathématiques et physiques du même ordre conduisent à un choix de n maximum égal à (nr + nz - 2). Ainsi, connaissant nr, np, nz donc P, on en déduit l'ordre supérieur de l'expression analytique. L'augmentation de l'un entraîne celle de l'autre. Dans un exemple on a ainsi découvert pour un volume cylindrique d'intérêt, dont le diamètre, égal à la longueur, vaut de l'ordre de 50cm, que la connaissance du champ en 451 points (nr = 6, np = 8, nz = 11) permet d'exprimer analytiquement le champ avec des harmoniques sphériques jusqu'à l'ordre n = 15 et m = 4 avec un écart quadratique moyen d'une partie par million.

La présente invention quoique décrite dans une solution où le réglage est simple (par réglage de courant dans des bobines de correction) n'est cependant pas limitée à cette application. En particulier il est possible d'utiliser des morceaux d'aimants permanents de formes, de dimensions, et d'aimantation appropriées ainsi que des pièces aimantables (en fer doux) de formes, de dimensions et de susceptibilité magnétique choisies. Ces "cales" magnétiques ou magnétisables sont placées à proximité de l'aimant. Elles exercent leur influence principalement sur le volume d'intérêt 2. Le réglage peut être exercé sous une forme quelconque mais d'une manière préférée il est obtenu en modifiant l'orientation de ces cales. De telles réalisations sont décrites dans une demande de brevet conjointe déposée le même jour par la demanderesse. Dans ce cas, les paramètres $K_i$ doivent être remplacés par des fonctions de paramétrisation. Ces fonctions de paramétrisation correspondent à des changements d'orientation des cales magnétiques. La notion de composition algébrique des expressions analytiques, revendiquée ci-dessus, s'étend aussi à ce cas. Elle y signifie en fait composition algébrique des termes des expressions analytiques. En effet ces termes y sont paramétrés en fonction des angles de pointage des cales.

## Revendications

1. Procédé de réglage des correcteurs d'homogénéité du champ magnétique créé par un aimant, caractérisé en ce qu'il comporte les phases suivantes :
   - on mesure (18-25) le champ réel créé par l'aimant,
   - on calcule l'expression analytique, suivant une base de fonctions orthogonales de ce champ mesuré,
   - on calcule les expressions analytiques, suivant la même base, des champs produits par les moyens de correction en fonction de leur état de réglage,
   - on calcule l'expression analytique, suivant le même base, d'un champ idéal à obtenir avec l'aimant,
   - on procède à une composition algébrique des expressions analytiques des champs de correction pour la rendre égale, et de signe contraire, à la différence des expressions analytiques du champ réel et idéal,
   - et on règle (14-17) les moyens de correction en fonction des résultats de cette composition algébrique.

2. Procédé selon la revendication 1, caractérisé en ce que pour calculer l'expression analytique des champs produits par les moyens de correction, on mesure le champ que produit chacun de ces moyens dans un état de réglage donné.

3. Procédé selon l'une quelconque des revendications 1 ou 2, caractérisé en ce que pour calculer les expressions analytiques, on calcule les décompositions en harmoniques sphériques des champs produits.

4. Procédé selon l'une quelconque des revendications 1 ou 2, caractérisé en ce que pour le calcul des expressions analytiques des champs, on calcule les décompositions en harmoniques cylindriques des champs produits.

5. Procédé selon l'un quelconques des revendications 1 à 4, caractérisé en ce que pour mesurer le champ on déplace une sonde de mesure en un certain nombre de points répartis cylindriquement à l'intérieur d'un volume d'intérêt.

6. Procédé selon la revendication 5, caractérisé en ce qu'après avoir calculé la décomposition en harmoniques sphériques du champ mesuré,
   - on calcule le champ magnétique correspondant à cette décomposition,
   - on compare le champ magnétique calculé au champ magnétique mesuré,
   - on déduit de cette comparaison le nombre minimal de points de mesure et l'ordre minimal de la décomposition compatibles avec la précision de l'appareil de mesure utilisé pour faire la mesure et/ou avec la tolérance à respecter par le champ réel.

## Claims

1. A method for regulating the homogeneity correcting means for the magnetic field created by a magnet, characterized in that it comprises the following phases :
   - the real field created by the magnet is measured (18 through 25),
   - the analytical expression is calculated observing a base of orthogonal functions of the measured field,
   - observing the same base the analytical expressions of the fields produced by the correction means are calculated as a function of their state of regulation,
   - observing the same base the analytical expression of an ideal field to be obtained with the magnet is calculated,
   - the analytical expressions of the correction fields are then algebraically composed to render them equal, and of opposite sign, to the difference of the analytical expressions of the real and ideal field,
   - and the correction means are regulated (14 through 17) as a function of the results of this algebraic composition.

2. The method as claimed in claim 1, characterized in that in order to calculate the analytical expression of the fields produced by the correction means, the field produced by each of these means is measured in a given state of regulation.

3. The method as claimed in claim 1 or claim 2, characterized in that in order to calculate the analytical expressions the decomposition of the fields produced is calculated in spherical harmonics.

4. The method as claimed in claim 1 or claim 2, characterized in that in order to calculate the analytical expressions the decomposition of the fields produced is calculated in cylindrical harmonics.

5. The method as claimed in any one of the preceding claims 1 through 4, characterized in that in order to measure the field a measuring probe is shifted to a certain number of points distributed cylindrically in the interior of a volume of interest.

6. The method as claimed in claim 5, characterized in that after having calculated the decomposition of the measured field in spherical harmonics,
   - the magnetic field corresponding to this decomposition is calculated,
   - the calculated magnetic field is compared with the measured magnetic field, and
   - from this comparison the minimum number of measurement points and the minimum order of the decomposition are deduced which are compatible with the precision of the measuring apparatus, used to carry out the measurements and/or with the tolerance to be adhered to by the real field.

## Ansprüche

1. Verfahren zur Steuerung von Korrekturvorrichtungen für die Homogenität eines von einem Magneten erzeugten Magnetfeldes, dadurch gekennzeichnet, daß es die folgenden Phasen umfaßt:
   - Messung (18-25) des vom Magneten tatsächlich erzeugten Feldes,
   - Berechnung des in einer Funktionen-Orthogonalbasis dargestellten analytischen Ausdrucks dieses gemessenen Feldes,
   - Berechnung der analytischen Ausdrücke der von den Korrekturmitteln in Abhängigkeit ihres Steuerzustandes erzeugten Felder in einer Darstellung in derselben Funktionen-Orthogonalbasis,
   - Berechnung des analytischen Ausdrucks eines mit dem Magneten zu erzielenden idealen Feldes in einer Darstellung in derselben Funktionen-Orthogonalbasis,
   - Ausführung einer algebraischen Zusammensetzung der analytischen Ausdrücke der Korrekturfelder, damit diese, mit entgegengesetzten Vorzeichen, gleich der Differenz zwischen den analytischen Ausdrücken des tatsächlichen und des idealen Feldes wird,
   - und Steuerung (14-17) der Korrekturmittel in Abhängigkeit der Ergebnisse dieser algebraischen Zusammensetzung.

2. Verfahren gemäß Anspruch 1, dadurch gekennzeichnet, daß für die Berechnung des analytischen Ausdrucks der von den Korrekturmitteln erzeugten Felder das Feld gemessen wird, das jedes dieser Mittel in einem gegebenen Steuerzustand erzeugt.

3. Verfahren gemäß einem der Ansprüche 1 oder 2, dadurch gekennzeichnet, daß für die Berechnung der analytischen Ausdrükke die Zerlegungen in die Kugelfunktionen der erzeugten Felder berechnet werden.

4. Verfahren gemäß einem der Ansprüche 1 oder 2, dadurch gekennzeichnet, daß für die Berechnung der analytischen Ausdrükke der Felder die Zerlegungen in die Zylinderfunktionen der erzeugten Felder berechnet werden.

5. Verfahren gemäß einem der Ansprüche 1 bis 4, dadurch gekennzeichnet, daß für die Messung des Magnetfeldes eine Meßsonde zwischen einer bestimmten Anzahl von Punkten verschoben wird, die im Inneren eines fraglichen Volumens zylindrisch verteilt sind.

6. Verfahren gemäß Anspruch 5, dadurch gekennzeichnet, daß nach der Berechnung der Zerlegung in Kugelfunktionen des gemessenen Feldes
- das dieser Zerlegung entsprechende Magnetfeld berechnet wird,
- das berechnete Magnetfeld mit dem gemessenen Magnetfeld verglichen wird,
- aus diesem Vergleich die Mindestanzahl der Meßpunkte und die kleinste Ordnung der Zerlegung, die mit der Genauigkeit des für die Ausführung der Messung verwendeten Meßgerätes und/oder mit der für das tatsächliche Feld annehmbaren Toleranz kompatibel sind, abgeleitet werden.